Europäisches Patentamt

European Patent Office

Office européen des brevets

(19)

(11) Publication number: **0 151 347**
**B1**

(12) **EUROPEAN PATENT SPECIFICATION**

(45) Date of publication of patent specification: **26.10.88**

(51) Int. Cl.⁴: $H\ 01\ L\ 21/82$, $H\ 01\ L\ 27/06$

(21) Application number: **84308802.2**

(22) Date of filing: **17.12.84**

(54) **Integrated circuit having bipolar and field effect devices and method of fabrication.**

(30) Priority: **16.01.84 US 571002**

(43) Date of publication of application:
**14.08.85 Bulletin 85/33**

(45) Publication of the grant of the patent:
**26.10.88 Bulletin 88/43**

(84) Designated Contracting States:
**DE FR GB**

(56) References cited:
**EP-A-0 032 550**
**EP-A-0 093 304**
**EP-A-0 110 313**
**DE-A-2 449 012**
**US-A-4 325 180**

(73) Proprietor: **TEXAS INSTRUMENTS
INCORPORATED**
**13500 North Central Expressway**
**Dallas Texas 75265 (US)**

(72) Inventor: **Morris, Frank J.**
**1036 Sunswept Terrace**
**Plano Texas (US)**

(74) Representative: **Abbott, David John et al**
**Abel & Imray Northumberland House 303-306**
**High Holborn**
**London, WC1V 7LH (GB)**

Courier Press, Leamington Spa, England.

## Description

### Background and Summary of the Invention The present invention relates generally to electronic integrated circuits and more specifically to a method for fabricating field effect and bipolar devices on a single substrate, and the devices so produced.

Different device types used in the construction of integrated circuits have various strengths and weaknesses which must be considered when designing such circuits. For example, bipolar circuits can be made fast and capable of high output current drive capacity. Bipolar devices are also easily designed as TTL circuitry, an important consideration when interfacing with other logic devices is considered. CMOS devices exhibit good packing density, good speed and very low power consumption under most conditions. NMOS devices can be used where high packing density and speed are required, but draw more power than CMOS devices. The combinations of different devices on a single integrated circuit substrate would yield improved results in many cases.

The combination of CMOS and bipolar devices on a single integrated circuit chip would yield a device having many advantages over the use of either technology alone. The use of CMOS technology for logic and memory, and bipolar technology for input/output, (I/O) would result in a device having overall low power consumption, good packing density and the capacity to drive highly capacitive loads. There is potential for high speed operation if parasitic capacitances can be reduced.

One previous technique for integrating bipolar and CMOS devices onto a single substrate is shown by U.S. Patent No. 4,325,180, PROCESS FOR MONOLITHIC INTEGRATION OF LOGIC, CONTROL, AND HIGH VOLTAGE INTERFACE CIRCUITRY, issued April 20, 1982 to P. Curran. Devices constructed according to such reference have a number of drawbacks, including relatively high parasitic capacitance between devices and latchup of the CMOS devices. In addition, the processing steps are fairly complex, resulting in more expensive integrated circuits.

Another reference indicating the current state of the art is U.S. Patent No. 4,299,024, FABRICATION OF COMPLEMEMTARY OF BIPOLAR TRANSISTORS AND CMOS DEVICES WITH POLY GATES, issued November 10, 1981 to Piotrowski. In this reference, all devices are oxide insulated, and are fabricated within a substrate layer. Another reference, U.S. Patent No. 4,050,965, SIMULTANEOUS FABRICATION OF CMOS TRANSISTORS AMD BIPOLAR DEVICES, issued September 27, 1977 to Ipri et al., describes the fabrication of CMOS and bipolar devices on a sapphire substrate.

Devices constructed according to these references have a number of drawbacks, including difficulty of fabrication, CMOS latchup problems, and low operating speeds due to parasitic capacitances.

In EP-A-0 078 571 there is described a method of making an integrated circuit in which regions of a substantially undoped epitaxial layer are doped with different dopants by upward diffusion from highly doped buried regions formed in the substrate. The dopants have substantially equal diffusion velocities so that isolating PN junctions are formed between the regions substantially at right angles to the surface of the epitaxial layer. Field effect and bipolar transistors are described as being made in the different regions.

It would be desirable for a single integrated circuit to incorporate both CMOS and bipolar devices for the reasons described above. Such an integrated circuit would take advantage of the strengths of each device type, allowing very low overall power drain with the improved I/O capabilities of bipolar devices. Such an integrated circuit would preferably have very low parasitic capacitances, allowing high operating speed. It is also desirable that such a circuit eliminate latchup of the CMOS components during transient conditions. It would also be desirable that such an integrated circuit be compatible with standard TTL devices, allowing incorporation without buffering into systems utilizing other TTL devices. It would be further desirable that such an integrated circuit be easy and flexible for a design engineer to use, and that the fabrication processes be compatible with standard bipolar fabrication processes. This would allow such integrated circuits to have maximum usefulness and be cheaply fabricated.

According to one aspect of the present invention there is provided a method for fabricating a monolithic integrated circuit having insulated gate device and bipolar devices, comprising the steps of: (a) forming $n^+$ regions at the surface of a monocrystalline p-type semiconductor substrate where p-channel, bipolar and resistive devices are to be fabricated; (b) forming $p^+$ regions at the surface of the substrate where n-channel devices are to be fabricated; (c) epitaxially forming an n-type semiconductor layer over the entire surface of the substrate; (d) removing a portion of the depth of the epitaxially formed n-type layer, except where p-channel, n-channel, bipolar and resistive devices are to be fabricated, to define shallow regions; (e) oxidizing the shallow regions to at least the surface of the substrate, wherein isolated regions are formed where p-channel, n-channel, bipolar and resistive devices are to be formed, (f) causing, mostly during said oxidizing step, the $p^+$ regions formed where n-channel devices are to be fabricated to diffuse into the overlying n-type epitaxial layer, wherein a p-type isolated region is formed; and (g) fabricating p-channel, n-channel, bipolar and resistive devices in the isolated regions.

According to a second aspect of the present invention there is provided a monolithic integrated circuit having an n-channel and a p-channel insulated gate field effect devices, and bipolar devices on a single substrate, comprising: (a) a substrate of a first conductivity type; (b) an insulating layer adjoining said substrate at a surface; (c) a tank region of a second conductivity type located within said insulating layer adjacent said substrate;

(d) a highly doped region of the second conductivity type located between said second conductivity type tank region and said substrate; (e) a tank region of the first conductivity type, wherein at least a portion thereof is located within said insulating layer; (f) source and drain regions of the first conductivity type located within said second conductivity type tank region; (g) source and drain regions of the second conductivity type located within said first conductivity type tank region; (h) gate regions located in said first and second conductivity type tank regions; and (i) bipolar transistors located in at least one of said tank regions.

Brief Description of the Drawings

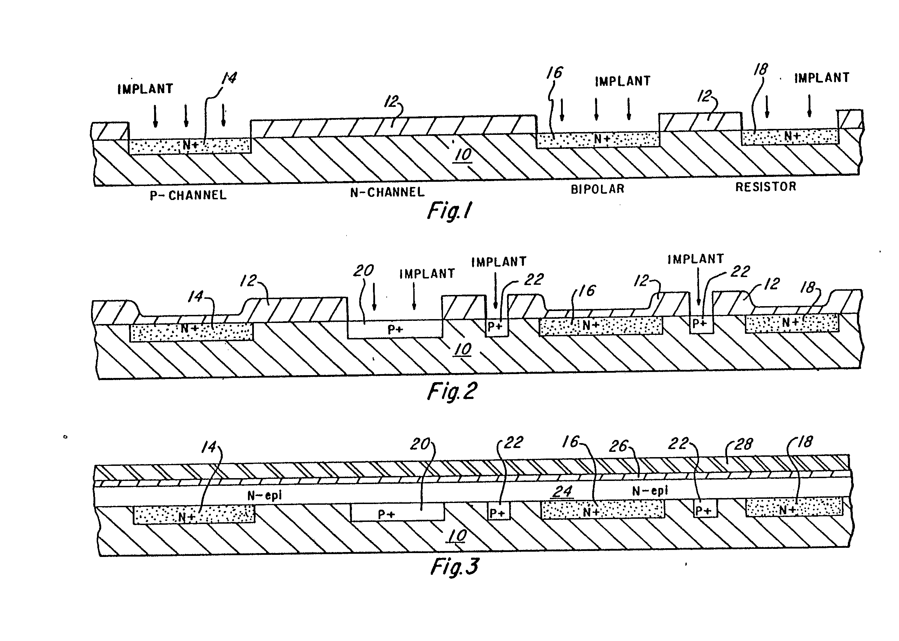

Figures 1-9 are enlarged cross sections of a semiconductor slice, not to scale, serving to illustrate the sequence of process steps for the fabrication of circuits in accordance with an embodiment of the present invention. For ease of illustration, all diffusions are assumed to be complete in the designated cross section, whereas in reality certain diffusions are interrupted for other implants or depositions and may not be complete until subsequent thermal cycles are completed.

Description of the Preferred Embodiments

Referring to Figure 1, P-type silicon with a resistivity of greater than 10 ohm-cm is used as a substrate 10. The substrate 10 is heated in an oxidizing ambient to form an oxide layer 12. A photoresist pattern (not shown) is used to define the regions where p-channel MOS, bipolar and resistive devices are to be fabricated. Alternatively, an E-beam pattern can be used. The preference of photoresist or E-beam resist is immaterial to the present invention. The oxide layer 12 is removed from the locations for the p-channel, bipolar, and resistor devices. Antimony is then implanted into these regions to form n+ buried layers 14, 16, 18.

Referring to Figure 2, the antimony implant is annealed at 1250°C for about thirty minutes in an oxidizing ambient. A second resist pattern (not shown) is used to define the regions for building the n-channel MOS transistors and the channel stop regions for the bipolar devices. The oxide 12 is removed from these regions, and a high density boron implant is made into the substrate, forming p+ tank and channel stop regions 20, 22. The resist is stripped and the boron annealed at 900°C.

Referring to Figure 3, all remaining oxide 12 is stripped from the substrate 10, and an n-type epitaxial layer 24 is grown thereon. The resistivity of this layer 24 is approximately 1 ohm-cm. In the preferred embodiment, the epitaxial layer 24 is 1.3 micrometers thick, but can be grown anywhere in the range from approximately 1 to 1.5 micromters in thickness. The epi layer 24 is oxidized to create a thin oxide layer 26, and a nitride layer 28 is deposited upon the oxide layer 26. In the preferred embodiment, the oxide layer 26 is 60 nanometers and the nitride layer 28 is 110 nanometers in depth. The thickness of these two layers 26, 28 is not extremely critical. The oxide layer 26 may be in the range of 300-800 angstroms, and the nitride layer 28 should be greater than approximately 1000 angstroms in thickness.

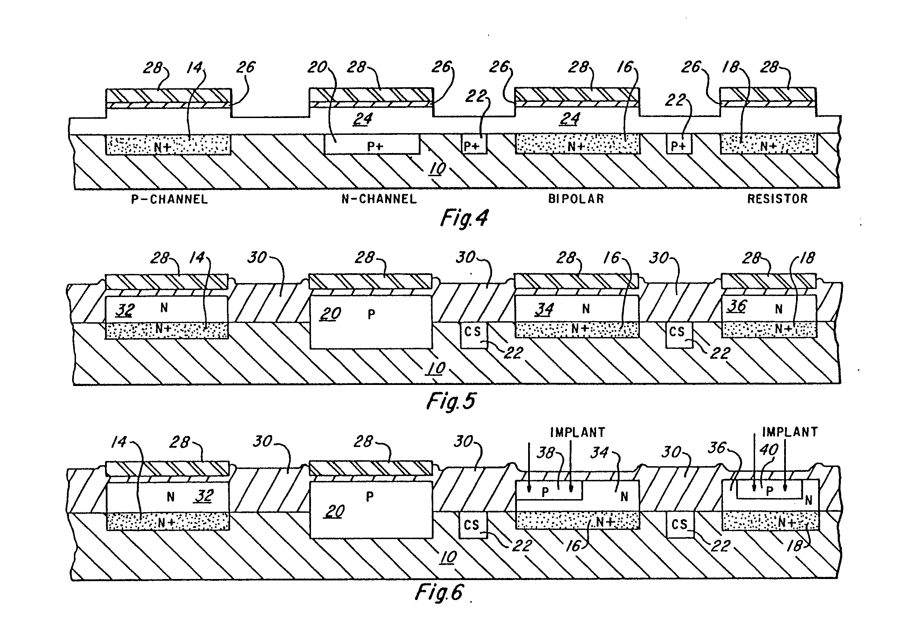

Referring to Figure 4, resist (not shown) is patterned to cover the MOS transistor locations, the bipolar transistor locations and the resistor locations. The nitride and oxide layers 26, 28 are etched from the unprotected regions, and the epitaxial layer 24 is dry etched to approximately one-half of its depth, for example to a depth of .6 microns, over the unmasked areas of the substrate 10. The resist is then removed.

Referring to Figure 5, a thick isolation oxide 30 is thermally grown to convert the exposed portions of the epitaxial layer 24 to oxide 30. The size differential between oxide and epitaxial silicon causes the isolation oxide portions to be approximately 1.3 to 1.4 micrometers thick. The oxidation proceeds at least to the surface of the substrate 10, and perhaps slightly beyond. This separates the chip into isolated tanks 32, 20, 34, 36, each of which will become the location for one transistor or resistive device.

During this high temperature thermal oxidation step, the high density boron implant 20 diffuses into the epitaxial layer directly above and converts it to p-type silicon. The boron also diffuses laterally and down into the substrate 10 as shown in Figure 5. As seen by comparing Figures 4 and 5, the original boron implant 20 is made smaller than the final design size of the p tank 20 in order to allow for this diffusion. In actuality, this diffusion process will not be entirely completed at this point. However, the majority of the boron diffusion does take place while the isolation oxide layer 30 is being grown. For simplicity of illustration, the entire up-diffusion process is shown as taking place at this time, and it is understood that some additional diffusion will take place during later high temperature process steps. While the isolation oxide 30 is being grown, the boron implanted for the hipolar channel stops 22 also diffuses to the desired size. For ease of illustration, the channel stops 22 are shown as having grown to their final size, although some diffusion will take place during later stages as described above with reference to the p tank 20.

When the process has reached the point shown in Figure 5, all of the isolated wells 32, 20, 34, 36 for the various components have been formed, and all that remains is to actually form the various active and passive structures. From this point, several different process flows may be utilized to fabricate the end product, some of which will become apparent to those skilled in the art. The actual process flow utilized may depend on the particular facilities available to the manufacturer as well as details of the particular circuitry being fabricated.

A preferred fabrication process flow is shown beginning with Figure 6. Referring to Figure 6, the CMOS area (field effect devices) is covered with resist (not shown) and the nitride 28 is plasma etched from over the bipolar and resistor elements. The oxide 30 over the areas to contain the bipolar transistors and resistive elements is thermally grown to a depth of approximately 250 nanometers A resist pattern (not shown) is laid down, and boron is implanted in the bipolar transistor regions through the overlying oxide layer 30. This forms a p-type implanted region 38 which will become the intrinsic base of the bipolar transistor. Another p-type region 40 is implanted to form a conductive path for the resistors.

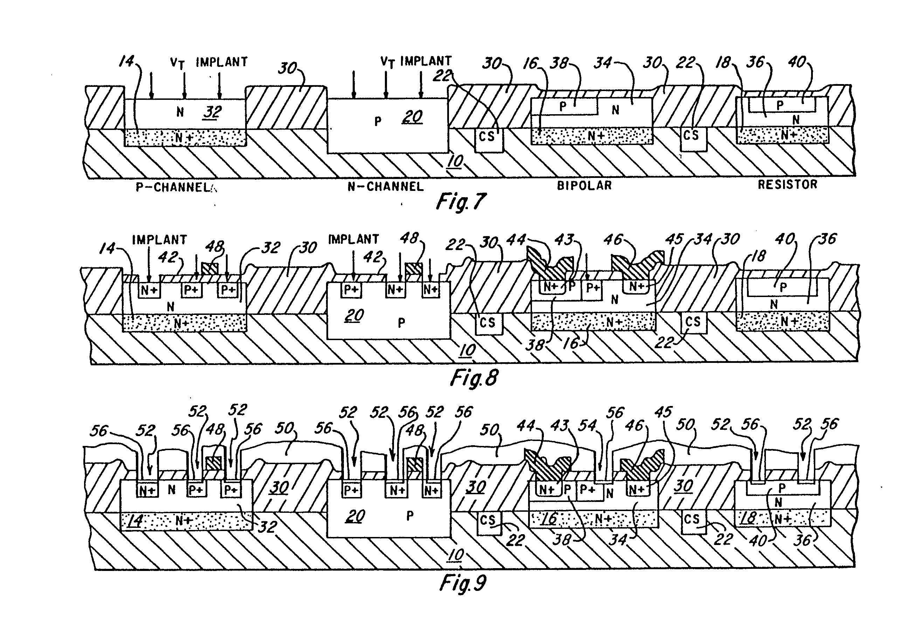

Referring to Figure 7, all of the remaining resist is stripped and the nitride 28 over the CMOS tanks is removed with phosphoric acid. A resist mask (not shown) is patterned and boron is implanted at the surface of the n-type tank 32 to control the threshold voltage ($V_T$) for the p channel FET. Another resist mask (not shown) is patterned and boron is implanted at the surface of the p-type tank 20 to control $V_T$ of the n channel FET. The 60 nanometer oxide layer 26 grown in Figure 3 is still present over the CMOS tanks during this implantation. All resist is then stripped, and 60 nanometers of oxide is removed. Since the oxide over all other areas of the chip is much thicker than 60 nanometers, no masking is required for this step.

Referring to Figure 8, a thin layer of gate oxide 42 is grown on the surface of the chip. In the preferred embodiment, this forms a 50 nanometer oxide layer 42 over both the n and p tanks. Again, no masking is required for this step. The heating required to grow this gate oxide layer 42 also serves to anneal the boron implants 38, 40 made in the bipolar and resistor regions, as well as the $V_T$ control implants. A resist mask (not shown) is patterned, and the oxide layer is etched to open emitter and collector contacts for the bipolar transistors. A layer of polycrystalline silicon is laid down. The polysilicon can be doped n-type at this time with an arsenic or phosphorous implant. Later annealing steps will cause diffusion into the silicon below the emitter and collector openings, forming an n+ emitter region 43 and an n+ collector contact region 45. An alternative, later polysilicon doping step is described below. The polysilicon is then patterned and etched, leaving polysilicon only as contacts 44, 46 to the emitter and collector contact regions 43, 45 of the bipolar transistors, and to serve as gate contacts 48 for the MOS transistors. A resist mask (not shown) is patterned to expose the source and drain regions of the p-channel FET and the substrate contact for the n-channel FET. The bipolar intrinsic base region is also left exposed. The oxide over these regions is not etched, and boron is implanted into the p+ regions as shown by the arrows. The boron inmplant is then annealed. Another resist mask is patterned to expose the source and drain regions for the n-channel FET, and the substrate contacts for the p-channel FET. The oxide covering these regions is etched, and arsenic is implanted and annealed to form the n+ regions as shown in Figure 8. The poly gates 48 can be used to self-align the source and drain regions of the field effect devices.

As an alternative to the polysilicon doping process described above, the polysilicon can be left undoped until after it is patterned. The arsenic implant used to form the n+ source and drain regions in the n-channel transistor can also be used to dope the patterned polysilicon. The emitter region 43 and the collector contact region 45 will be formed by diffusion from the polysilicon during the anneal step.

Referring to Figure 9, a layer of phosphosilicate glass 50 (PSG) is deposited in a conventional manner, and heated to reflow. All metallic contact regions 52, 54 are then opened through the PSG layer 50 and the oxide layer where that layer still exists. As shown in Figure 9, base contact opening 54 is positioned to fabricate the bipolar transistor as a Schottky transistor. This is a preferred embodiment due to the faster switching speed and lower power drain of Schottky devices, but is not a requirement of the present invention. In order to form a better contact, 50 nanometers of platinum is deposited, sintered and stripped with aqua regia as known in the art. A thin layer of platinum silicide 56 remains in each contact opening 52, 54. The process to this stage results in the structure of Figure 9, and from this point conventional methods are used to attach the metallic contacts. For example, a titanium-tungsten layer of 200 nanometers thick is deposited, followed by a 600-700 nanometer deposit of copper doped aluminum. The titanium-tungsten layer acts as a barrier layer to prevent aluminum from diffusing through the platinum silicide layers 56 and destroying the integrity of the contact. The metal leads are then patterned. A second level of metal can be deposited, if required, in a conventional manner.

The process described above results in CMOS and bipolar devices fabricated on the same chip. This allows an integrated circuit device to be designed which takes advantage of the strengths of different device types. For example, the majority of circuit logic can be made of CMOS devices, with bipolar I/O drivers. This results in a device having an overall very low power consumption, with the superior input buffering and output drive capabilities of bipolar devices. The bipolar I/O can easily be fabricated as standard TTL, allowing the integrated circuit to be used with other TTL devices without buffering. When Schottky contacts such as those shown in FIG. 9 are used, the bipolar I/O can be designed using the various types of Schottky TTL which are generally available. The device shown in Figure 9 has oxide isolated active devices instead of using junction isolation, which allows a greater packing density while decreasing parasitic capacitances of the active devices. These low capacitances result in higher speed operation for both the CMOS and bipolar circuitry.

The CMOS devices will be virtually free from latchup during transient conditions. As seen in Figure 9, the parasitic transistors which can cause latchup are formed by the p+ source and drain/n-tank/p-substrate and the n+ source and drain/p-tank/n-tank. The gain of both of these parasitic transistors is extremely low, making latchup extremely unlikely. The gain of the parasitic PNP transistor is low due to the high base charge resulting from the n+ buried layer 14 under the p-channel FET. The gain of the parasitic NPN transistor will also be extremely low because the base, formed by the substrate and the p-tank, is very wide and has a relatively large base charge due to the heavy boron implant from which the p tank was formed. Given both of these extremely low parasitic transistor gains, the gain product of the parasitic transistors will be much less than the unity value necessary for latchup.

The process described above can be easily adapted to create many different configurations which might be desired by the designer. The fabrication of CMOS devices gives fairly high packing density with low power consumption. Packing density can be increased further by fabricating more than one FET in each tank. If power were a less important consideration, NMOS devices could be combined with bipolar I/O to give an integrated circuit with much higher packing density. As another example, it might be desirable to fabricate a complete microcomputer on a single integrated circuit which takes advantage of the best features of several device types. CMOS devices could be fabricated as above and used for static RAM and logic, with bipolar devices as described above used for improved I/O. With very minor process changes, the MOS devices could be used to fabricate dynamic RAM, which would allow a greate deal of memory to be incorporated in a single high performance microcomputer chip. Also, the process could be expanded slightly to include polysilicon diode ROM in order to define a complete microcomputer on a single chip. A suitable ROM for use with this fabrication process is fully described in copending patent application entitled HIGH DENSITY BIPOLAR ROM HAVING A LATERAL PN DIODE AS A MATRIX ELEMENT AND METHOD OF FABRICATION, Ser. No. 289,357, filed August 3, 1981, and assigned to the assignee of the present application (US-A-4 516 223, published on May 7, 1985). Other modifications which can be made to the present fabrication process will become apparent to those skilled in the art. The process described above for fabricating CMOS and bipolar devices on a single chip, and the structure produced thereby, give a designer the flexibility to design integrated circuits which can perform nearly any conceivable function.

Formation of the p-tank or the n-channel FET as descrbibed above gives a device having superior characteristics. The doping density profile of the p-tank is the reverse of that found in the prior art. The highest dopant concentration is found at the center of the tank, with the concentration decreasing toward the surface. This results in a lower $V_T$ than found in prior art devices, which have a higher dopant concentration at the upper surface of the tank as a result of formation by the surface diffusion process. The lower surface dopant concentration resulting from the up-diffusion process described herein allows better $V_t$ control, through the later boron implant, than prior art devices.

Lateral PNP transistors can be easily fabricated with this technology by utilizing the n-tanks described above for use with the p-channel FETs. By changing the device geometries and eliminating the gate contact, as known in the art, the p-channel device described above is converted into a PNP lateral transistor. These bipolar devices can be used as TTL compatible inputs, for example when multiple emitter inputs are desired.

The process described above can be scaled to devices of very small size, including one micrometer geometries. One size limit to the process as described above is based on the extent of diffusion of the boron implanted to form the p tank 20 for the n-channel FET. For improved geometry control at very small scales, the boron implant step can be delayed until later in the process. For example, the boron implant process in the n-channel regions, discussed in connection with Figure 2, can be omitted. The process then continues as described through the steps described in connection with Figure 5. Without the boron implant, at this point the tank wherein the n-channel MOS devices will be located is n-type. After the field oxide has heen grown, boron can be implanted into this region at 400 - 600 KeV. This implant is then annealed, and diffusion will be limited because there are few extended, high temperature process steps after this stage. The later boron implant procedure is a more costly process, and would generally only be utilized when density requirements forbid the use of the less geometrically well defined up diffusion process described above.

Although preferred embodiments have been described in detail, it should be understood that various additions and modifications can be made to the present invention without departing therefrom. The preferred embodiments are intended only to illustrate the principles of the invention, the scope of which is defined by the appended claims.

**Claims**

1. A method for fabricating a monolithic integrated circuit having insulated gate devices and bipolar devices, comprising the steps of:

(a) forming $n^+$ regions at the surface of a monocrystalline p-type semiconductor substrate where p-channel, bipolar and resistive devices are to be fabricated;

(b) forming $p^+$ regions at the surface of the substrate where n-channel devices are to be fabricated;

(c) epitaxially forming an n-type semiconductor layer over the entire surface of the substrate;

(d) removing a portion of the depth of the epitaxially formed n-type layer, except where p-channel, n-channel, bipolar and resistive devices are to be fabricated, to define shallow regions;

(e) oxidizing the shallow regions to at least the surface of the substrate, wherein isolated regions are formed where p-channel, n-channel, bipolar and resistive devices are to be formed,

(f) causing, mostly during said oxidizing step, the $p^+$ regions formed where n-channel devices are to be fabricated to diffuse into the overlying n-type epitaxial layer, wherein a p-type isolated region is formed; and

(g) fabricating p-channel, n-channel, bipolar and resistive devices in the isolated regions.

2. A method according to claim 1, wherein step (b) further comprises the step of simultaneously forming $p^+$ regions at the surface of the substrate to define channel stops.

3. A method according to claim 1 or 2, wherein step (g) comprises steps of:

(h) forming regions of a first conductivity type in selected isolated regions of the second conductivity type to form resistive devices;

(i) forming p-type regions in selected isolated regions to form base regions for bipolar devices;

(j) forming gate contacts on selected isolated regions for p-channel and n-channel devices;

(k) forming emitter and collector contacts on selected isolated regions for bipolar devices;

(l) forming $p^+$ regions in selected isolated regions to create source and drain regions for p-channel devices; and

(m) forming $n^+$ regions in selected isolated regions to create source and drain regions for n-channel devices.

4. A method according to claim 3, wherein the gate contacts, and the emitter and collector contacts, are formed from polysilicon.

5. A method according to any preceding claim, wherein steps (e) and (f) are performed simultaneously.

6. A monolithic integrated circuit having an n-channel and a p-channel insulated gate field effect devices, and bipolar devices on a single substrate, comprising:

(a) a substrate of a first conductivity type;

(b) an insulating laer adjoining said substrate at a surface;

(c) a tank region of a second conductivity type located within said insulating layer adjacent said substrate;

(d) a highly doped region of the second conductivity type located between said second conductivity type tank region and said substrate;

(e) a tank region of the first conductivity type, wherein at least a portion thereof is located within said insulating layer;

(f) source and drain regions of the first conductivity type located within said second conductivity type tank region;

(g) source and drain regions of the second conductivity type located within said first conductivity type tank region;

(h) gate regions located in said first and second conductivity type tank regions; and

(i) bipolar transistors located in at least one of said tank regions.

7. An integrated circuit according to claim 6 wherein said first and second condutivity types are p-type and n-type respectively.

8. An integrated circuit according to claim 6 wherein said first and second conductivity types are n-type and p-type respectively.

**Patentansprüche**

1. Verfahren zum Herstellen einer monolithischen integrierten Schaltung mit Anordnungen mit isolierter Gate-Elektrode sowie mit bipolaren Anordnungen, enthaltend die Schritte.

(a) Bilden von $n^+$-Zonen an der Oberfläche eines monokristallinen, p-leitenden Halbleitersubstrats, wo bipolare und ohmsche p-Kanal-Anordnungen gebildet werden sollen;

(b) Bilden von $p^+$-Zonen an der Oberfläche des Substrates wo n-Kanal-Anordnungen hergestellt werden sollen;

(c) epitaxisches Bilden einer n-leitenden Halbleiterschicht über der gesamten Oberfläche des Substrats;

(d) Entfernen eines Teils der Tiefe der epitaxisch gebildeten n-leitenden Schicht zur Bildung flacher Zonen, mit Ausnahme der Stellen, an denen p-Kanal-, n-Kanal-, bipolare und ohmsche Anordnungen hergestellt werden sollen;

(e) Oxidieren der flachen Zonen bis wenigstens zur Oberfläche des Substrats, wobei dort isolierte Zonen entstehen, wo p-Kanal-, n-Kanal-, bipolare und ohmsche Anordnungen hergestellt werden sollen;

(f) Hervorrufen einer Diffusion der $p^+$-Zonen, die dort gebildet worden sind, wo n-Kanal-Anordnungen hergestellt werden sollen, hauptsächlich während des Oxidationsschritts in die darüberliegende n-leitende epitaxische Schicht, in der eine p-leitende isolierte Zone gebildet wird; und

(g) Herstellen von p-Kanal-, n-Kanal-, bipolaren und ohmschen Anordnungen in den isolierten Zonen.

2. Verfahren nach Anspruch 1, bei welchem der Schritt (b) außerdem den Schritt des gleichzeitigen Herstellens von $p^+$-Zonen an der Oberfläche des Substrats zur Festlegung von Kanalbegrenzungen umfaßt.

3. Verfahren nach Anspruch 1 oder 2, bei welchem der Schritt (g) folgende Schritte umfaßt:

(h) Bilden von Zonen eines ersten Leitungstyps in ausgewählten isolierten Zonen des zweiten Leitungstyps zur Bildung ohmscher Anordnungen;

(i) Bilden von p-leitenden Zonen in den ausgewählten isolierten Zonen zur Bildung von Basisbereichen für bipolare Anordnungen;

(j) Bilden von Gate-Kontakten an ausgewählten isolierten Zonen für p-Kanal- und n-Kanal-Anordnungen;

(k) Bilden von Emitter- und Kollektor-Kontakten an ausgewählten isolierten Zonen für bipolare Anordnungen;

(l) Bilden von $p^+$-Zonen in ausgewählten isolierten Zonen zur Schaffung von Source- und Drain-Bereichen für p-Kanal-Anordnungen;

(m) Bilden von $n^+$-Zonen in ausgewählten isolierten Zonen zur Schaffung von Source- und Drain-Bereichen für n-Kanal-Anordnungen.

4. Verfahren nach Anspruch 3, bei welchen die Gate-Kontakte und die Emitter- und Kollektor-Kontakte aus Polysilizium gebildet werden.

5. Verfahren nach einem der vorhergehenden Ansprüche, bei welchem die Schritte (e) und (f) gleichzeitig ausgeführt werden.

6. Monolithische integrierte Schaltung mit N-Kanal-und P-Kanal-Feldeffektanordnungen mit isolierter Gate-Elektrode sowie mit bipolaren Anordnungen auf einem einzigen Substrat, mit:

(a) einem Substrat eines ersten Leitungstyps;

(b) einer an einer Fläche an das Substrat angrenzenden isolierenden Schicht,

(c) einer innerhalb der isolierenden Schicht angrenzend an das Substrat angeordnete Tankzone eines zweiten Leitungstyps;

(d) einer stark dotierten Zone des zweiten Leitungstyps, die zwischen der Tankzone des zweiten Leitungstyps und dem Substrat angeordnet ist;

(e) einer Tankzone des ersten Leitungstyps, wobei wenigstens ein Teil dieser Zone innerhalb der isolierenden Schicht liegt;

(f) Source- und Drain-Bereichen des ersten Leitungstyps, die innerhalb der Tankzone des zweiten Leitungstyps liegen;

(g) Source- und Drain-Bereichen des zweiten Leitungstyps, die innerhalb der Tankzone des ersten Leitungstyps liegen;

(h) Gate-Bereichen, die in den Tankzonen des ersten und des zweiten Leitungstyps liegen;

(i) bipolare Transistoren, die in wenigstens einer der Tankzonen liegen.

7. Integrierte Schaltung nach Anspruch 6, bei welcher der erste Leitungstyp der p-Leitungstyp und der zweite Leitungstyp der n-Leitungstyp ist.

8. Integrierte Schaltung nach Anspruch 6, bei welcher der erste Leitungstyp der n-Leitungstyp und der zweite Leitungstyp der p-Leitungstyp ist.

**Revendications**

1. Procédé de fabrication d'un circuit intégré monolithique comprenant des dispositifs à grille isolée et des dispositifs bipolaires, comportant les étapes suivantes:

(a) former des régions $n^+$ à la surface d'un substrat semi-conducteur monocristallin de type p, dans lequel des dispositifs résistants et bipolaires à canal p doivent être réalisés;

(b) former des régions $p^+$ à la surface du substrat dans lequel des dispositifs à canal n doivent être réalisés;

(c) former de manière épitaxiale une couche semi-conductrice de type n sur toute la surface du substrat;

(d) enlever une partie de la profondeur de la couche épitaxiale de type n, sauf à l'endroit où les dispositifs résistants et bipolaires à canal p et à canal n doivent être réalisés, pour définir des régions peu profondes;

(e) oxyder les régions peu profondes au moins jusqu'à la srface du substrat dans lequel sont f'ormées des régions isolées où des dispositifs résistants et bipolaires à canal p et à canal n doivent être formés;

(f) amener, le plus souvent lors de cette étape d'oxydation, les régions $p^+$ formées, où des dispositifs à canal n doivent être réalisés, à diffuser dans la couche épitaxiale de type n surjacente dans laquelle une région isolée de type p est formée; et

(g) réaliser des dispositifs résistants et bipolaires à canal n et à canal p dans les régions isolées.

2. Procédé conforme à la revendication 1, caractérisé en ce que l'étape (b) comprend également l'étape consistant à former simultanément des régions $p^+$ à la surface du substrat pour définir des arrêts de canal.

3. Procédé conforme à la revendication 1 ou 2, caractérisé en ce que l'étape (g) comprend les étapes suivantes:

(h) former des régions d'un premier type de conductibilité dans des régions isolées sélectionnées du second type de conductibilité pour former des dispositifs résistants;

(i) former des régions de type p dans des régions isolées sélectionnées pour former des régions de base pour des dispositifs bipolaires;

(j) former des contacts de grille sur des régions isolées sélectionnées pour des dispositifs à canal p et à canal n;

(k) former des contacts d'émetteur et de collecteur sur des régions isolées sélectionnées pour des dispositifs bipolaires;

(l) former des régions $p^+$ dans des régions isolées sélectionnées pour créer des régions de source et de drain pour des dispositifs à canal p; et

(m) former des régions $n^+$ dans des régions isolées sélectionnées pour créer des régions de source et de drain pour des dispositifs à canal n.

4. Procédé conforme à la revendication 3, dans lequel les contacts de grille et les contacts d'émetteur et de collecteur sont réalisés en polysilicium.

5. Procédé conforme à l'une quelconque des revendications précédentes, dans lequel les étapes (e) et (f) sont réalisées simultanément.

6. Circuit intégré monolithique comprenant des dispositifs à effet de champ à grille isolée à canal n et à canal p, et des dispositifs bipolaires sur un même substrat, comprenant:

(a) un substrat d'un premier type de conductibilité;

(b) une couche isolante adjacente audit substrat sur une surface;

(c) une région de puits d'un second type de conductibilité située à l'intérieur de ladite couche isolante adjacente audit substrat;

(d) une région fortement dopée du second type de conductibilité située entre ladite région de puits du second type de conductibilité et ledit substrat;

(e) une région de puits du premier type de conductibilité, dont au moins une partie est située à l'intérieur de ladite couche isolante;

(f) des régions de source et de drain du premier type de conductibilité situées à l'intérieur de ladite région de puits du second type de conductibilité;

(g) des régions de source et de drain du second type de conductibilité situées à l'intérieur de ladite région de puits du premier type de conductibilité;

(h) des régions de grille situées dans lesdites régions de puits du premier et du second type de conductibilité; et

(i) des transistors bipolaires situés dans au moins une desdites régions de puits.

7. Circuit intégré conforme à la revendication 6, caractérisé en ce que lesdits premier et second types de conductibilité sont de type p et, respectivement, de type n.

8. Circuit intégré conforme à la revendication 6, caractérisé en ce que lesdits premier et second types de conductibilité sont de type n et, respectivement, de type p.

0 151 347

IMPLANT   *14*

*12*   *16*   IMPLANT   *18*   IMPLANT

IMPLANT

N+   *10*   N+   N+

P- CHANNEL   N-CHANNEL   BIPOLAR   RESISTOR

*Fig. 1*

*14*   *12*   *20*   IMPLANT   IMPLANT   *22*   *16*   *12*   IMPLANT   *22*   *12*   *18*

N+   P+   *10*   P+   N+   P+   N+

*Fig. 2*

*14*   *20*   *22*   *16*   *26*   *22*   *28*   *18*

N-epi   *24*   N-epi

N+   P+   P+   N+   P+   N+

*10*

*Fig. 3*

28 14 26    20 28    26    26    28 16    26 18 28

N+    24    P+    P+    24    N+    P+    N+

22    22

*10*

P-CHANNEL    N-CHANNEL    BIPOLAR    RESISTOR

*Fig.4*

28 14    30    28    30    28 16    30    28 18

*32* N    *20* P    *34* N    *36* N

N+    CS    N+    CS    N+

22    22

*10*

*Fig.5*

14 28    30    28    30    IMPLANT    IMPLANT

38 34    30    36 40

N *32*    P *20*    P    N    P N

N+    CS    N+    CS    N+

22    16    22    18

*10*

*Fig.6*

**Fig.7**

P-CHANNEL   N-CHANNEL   BIPOLAR   RESISTOR

**Fig.8**

**Fig.9**

0 151 347